# EUROPEAN PATENT SPECIFICATION

(11) **EP 3 245 898 B1**
(45) Date of publication and mention of the grant of the patent: **20.08.2025**
(21) Application number: 17172056.8
(22) Date of filing: 19.05.2017
(51) Int. Cl.: A47B 91/16, B60B 33/00, H05K 5/02

(54) **CARRIER DEVICE CAPABLE OF VARYING CONTACT DAMPING WITH PRESSURED DISPLACEMENT**
TRÄGERVORRICHTUNG MIT FÄHIGKEIT ZUM ÄNDERN DER KONTAKTDÄMPFUNG MIT DRUCKVERDRÄNGUNG
DISPOSITIF DE SUPPORT POUVANT FAIRE VARIER UN AMORTISSEMENT DE CONTACT AVEC UN DÉPLACEMENT SOUS PRESSION

(30) Priority: 20.05.2016 US 201615159692
(43) Date of publication of application: 22.11.2017
(73) Proprietor: Yang, Tai-Her, Si-Hu Town Dzan-Hwa (TW)
(72) Inventor: Yang, Tai-Her, Si-Hu Town Dzan-Hwa (TW)
(74) Representative: Wright, Howard Hugh Burnby

(56) References cited:
- EP-A1- 2 949 307
- WO-A1-2015/118492
- US-A- 4 660 994
- US-A- 5 350 151
- US-B1- 6 594 856
- US-B1- 7 992 584

## Description

### BACKGROUND OF THE INVENTION

### (a) Field of the Invention

The present invention provides one or more carrier devices capable of varying contact damping with pressured displacement. The device is configured to be installed on mechanical force-receiving structures that have rolling wheels, rolling balls or slidably displaceable terminal block structure, carrying devices and transportation devices for humans or objects. When receiving pressure smaller than a set value, the device provides low contact damping and is thus easy to move. On the other hand, when receiving pressure greater than the set value, it provides high contact damping so as to prevent slip and thereby ensure safe placement. In addition, when receiving pressure smaller than the set value, the device has its pre-stressed structure generate modulation to displacement corresponding to the size of the pressure it receives for the purpose of shock absorbency.

### (b) Description of the Prior Art

The traditional mechanical force-receiving structures that have rolling wheels, rolling balls or slidably displaceable terminal block structure, carrying devices and transportation devices for humans or objects, such as chairs, tables, storage cabinets, tool cabinets, storage stools, rollators, transport carts, shopping carts, vehicles for people or goods, multifunction exercise bikes, mobile work platforms, mobile ladder stands, and mobile hangers. These mobile carriers for various loads are usually such designed that when receiving pressure smaller than a set value they provide low contact damping for easy movement, and when receiving pressure greater than the set value, they provide high contact damping for anti-slip, safe placement. One conventional approach to this end is blocking a force-receiving structure between the carrier device and its terminal support body from rolling by exerting an external force. This scheme, however, requires complicated operation in which a user tends to miss steps or make mistakes. Another solution works by making the carrying mechanism pressure and thus block the rolling mechanism under an increased load. In this case, the pressure made by the increased load to the carrying mechanism is directly put on the rolling mechanism, meaning that the original rolling mechanism is transformed to act as a terminal block providing high friction damping. Nevertheless this solution disadvantageously risks of damages to the rolling mechanism.

EP 2,949,307 A1 is directed to a walking aid device comprising a walking aid, an omni-directional wheel, and a buffering structure. Wherein, the buffering structure comprises an elastic component, and acts as a buffer to reduce the impact of bumpy roads or hard objects on the walking aid.

US 4,660,994 A1 is directed to a ball element for use in material handling equipment in which a rotatable ball is moveable by a pneumatic piston from a first to a second position relative to a friction surface.

WO 2015/118492 A1, disclosing a carrier device according to the preamble of claim 1, is directed to a rolling device comprising a rolling element and a piston that in a first position enables the rolling element to roll on a surface and in a second position retracts the rolling element away from the surface.US 6,594,856 B1 is directed to a pivotal retractable roller mechanism in which a roller may be moved between a non-contact position, and a contact position wherein it can roll along a surface. The roller mechanism comprises a spring to aid retraction.

US 5,350,151 is directed to a load supporting apparatus comprising a roller, a housing, and a compression spring. Wherein the roller is retracted by compression of the spring, enabling a surface to contact the floor and prevent further rolling.

### SUMMARY OF THE INVENTION

According to the invention, there is provided a carrier device as set out in claim 1. Optional features are set out in the dependent claims.

### BRIEF DESCRIPTION OF THE DRAWINGS

FIG. 1 schematically shows the main structure of the present invention.
FIG. 2 is a schematic cross-sectional view of the structure of FIG. 1 taken along Line A-A.
FIG. 3 schematically shows the structure of FIG. 1 wherein a load threshold set therefor is surpassed.
FIG. 4 schematically shows an embodiment of the assembled structure of FIG. 1.
FIG. 5 shows an exemplary arrangement constructed from a magnetic pre-stressed device (31) and a terminal block (71) having lower friction damping.
FIG. 6 is a schematic cross-sectional view of the structure of FIG. 5 taken along Line A-A.
FIG. 7 schematically shows an example of the assembled structure of FIG. 5.
FIG. 8 shows an exemplary arrangement constructed from a magnetic pre-stressed device (31) and a rolling wheel (72).
FIG. 9 is a schematic cross-sectional view of the structure of FIG. 8 taken along Line A-A.
FIG. 10 schematically shows an example of the assembled structure of FIG. 8.
FIG. 11 shows an exemplary arrangement constructed from a magnetic pre-stressed device (31) and a rolling ball (73).
FIG. 12 is a schematic cross-sectional view of the structure of FIG. 11 taken along Line A-A.
FIG. 13 is a schematic cross-sectional view of the structure of FIG. 11 taken along Line B-B.
FIG. 14 schematically shows an example of the assembled structure of FIG. 11.
FIG. 15 schematically shows an example of the arrangement according to FIG. 11 wherein an intermediate pad (735) is provided between the magnetic pre-stressed device (31) and the rolling ball (73).
FIG. 16 is a schematic cross-sectional view of the structure of FIG. 15 taken along Line A-A.
FIG. 17 is a schematic cross-sectional view of the structure of FIG. 15 taken along Line B-B.
FIG. 18 schematically shows an example of the assembled structure of FIG. 15.
FIG. 19 schematically shows an exemplary arrangement constructed from a magnetic pre-stressed device (31) and a semi-spherical terminal block (70a).
FIG. 20 is a schematic cross-sectional view of the structure of FIG. 19 taken along Line A-A.
FIG. 21 schematically shows an example of the assembled structure of FIG. 19.
FIG. 22 schematically shows an example of the structure of FIG. 19, wherein the semi-spherical terminal block (70a) is replaced with a semi-spherical cup-shaped structure (70c).
FIG. 23 schematically shows an exemplary arrangement constructed from a magnetic pre-stressed device (31) and a rolling wheel (72), which is of a one-side swinging structure.
FIG. 24 is a schematic cross-sectional view of the structure of FIG. 23 taken along Line A-A.
FIG. 25 schematically shows an example of the assembled structure of FIG. 23.
FIG. 26 is the first schematic structural embodiment of the present invention showing the pre-stressed structure (3) providing pressured displacement using energy stored as expansive prestress.
FIG. 27 is the second schematic structural embodiment of the present invention showing the pre-stressed structure (3) providing pressured displacement using energy stored as expansive prestress.
FIG. 28 schematically shows an embodiment that the present invention is provided with the axial rotating structure (21).

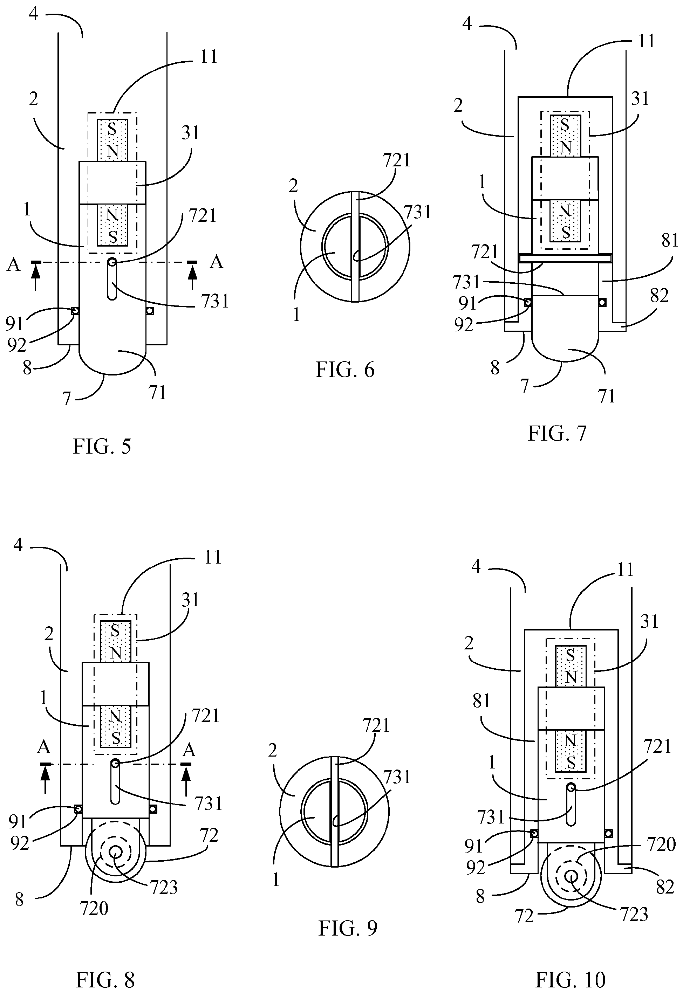

Figures 5-25 do not represent embodiments of the present invention.

### DESCRIPTION OF MAIN COMPONENT SYMBOLS

(1) : first force-receiving structure
(11) : limiting structure
(111) : guide rod
(2) : second force-receiving structure
(21) : axial rotating structure
(211) : shaft post
(212) : bearing
(213) : axial positioning annular slot
(214) : positioning ball
(215) : positioning bolt
(216) : hole seat
(217) : lateral screw hole
(3) : pre-stressed structure
(31) : magnetic pre-stressed device
(311) : permanent magnet
(312) : magnetic conductive member
(4) : carrying end
(5) : terminal support body
(6) : load
(7) : contact structure having lower friction damping
(70a) : semi-spherical terminal block
(70b) : annular flange structure
(70c) : semi-spherical cup-shaped structure
(70d) : outwardly-extended annular sheet
(71) : terminal block having lower friction damping
(72) : rolling wheel
(720) : bearing
(721), (724) : pin
(722) : wheel arm
(723) : shaft
(73) : rolling ball
(730) : limiting ring
(731) : guide slot
(735) : intermediate pad
(8) : contact structure having higher friction damping
(81) : assembled auxiliary for second force-receiving structure
(82) : flange
(83) : outer auxiliary for second force-receiving structure
(84) : inwardly-retracted flange
(91) : sealing ring
(92) : annular sealing slot
(1000) : carrier device assembly capable of varying contact damping with pressured displacement
(S1) : revolving axial line at carrying end
(S2) : pressure line of first force-receiving structure (1) and terminal support body (5)

### DETAILED DESCRIPTION OF THE PREFERRED EMBODIMENTS

The traditional mechanical force-receiving structures that have rolling wheels, rolling balls or slidably displaceable terminal block structure, carrying devices and transportation devices for humans or objects, such as chairs, tables, storage cabinets, tool cabinets, storage stools, rollators, transport carts, shopping carts, vehicles for people or goods, multifunction exercise bikes, mobile work platforms, mobile ladder stands, and mobile hangers. These mobile carriers for various loads are usually such designed that they when receiving pressure smaller than a set value provide low contact damping and are easy to move, and when receiving pressure greater than the set value, provide high contact damping for anti-slip, safe placement. One conventional approach to this end is blocking a force-receiving structure between the carrier device and its terminal support body from rolling by exerting an external force. This scheme, however, requires complicated operation in which a user tends to miss steps or make mistakes. Another solution works by making the carrying mechanism pressure and thus block the rolling mechanism under an increased load. In this case, the pressure made by the increased load to the carrying mechanism is directly put on the rolling mechanism, meaning that the original rolling mechanism is transformed to act as a terminal block providing high friction damping. Nevertheless this solution disadvantageously risks of damages to the rolling mechanism.

The present invention provides one or more carrier devices capable of varying contact damping with pressured displacement. The device is configured to be installed on mechanical force-receiving structures that have rolling wheels, rolling balls or slidably displaceable terminal block structure, carrying devices and transportation devices for humans or objects. In use, the carrier device capable of varying contact damping with pressured displacement when receiving pressure smaller than a set value, is easy to move, and when receiving pressure greater than the set value, provides anti-slip, safe placement. The carrier device generates displacement corresponding to the weight and/or pressure it receives at its carrying end (4), so as to provide variable friction damping between the carrying end (4) and a terminal support body (5) it contacts, and when receiving pressure smaller than a set value, the device has its pre-stressed structure generate modulation to displacement corresponding to the size of the pressure it receives for the purpose of shock absorbency.

The present invention features that the disclosed carrier device capable of varying contact damping with pressured displacement has its second force-receiving structure (2) provide one end thereof as a carrying end (4) for bearing a load or stress, that the second force-receiving structure (2) has a limiting structure (11) extended therefrom and linked thereto that works with a pre-stressed structure (3) to form a first force-receiving structure (1), and that the first force-receiving structure (1) and the second force-receiving structure (2) jointly transfer the pressure from the load or stress to a terminal support body (5) wherein the first force-receiving structure (1) and the second force-receiving structure (2) are both located between the carrying end (4) and the terminal support body (5) so as to function as desired by varying force distribution between the first and second force-receiving structures (1),(2) and the terminal support body (5) with the pressure acting on the carrying end (4);

Therein, the pre-stressed structure (3) is provided between the first force-receiving structure (1) and the limiting structure (11) that is extended from and linked to the second force-receiving structure (2), and forms a structure that generates displacement corresponding to a force it receives;

The main structure of the carrier device capable of varying contact damping with pressured displacement will be described below with reference to the drawings wherein:

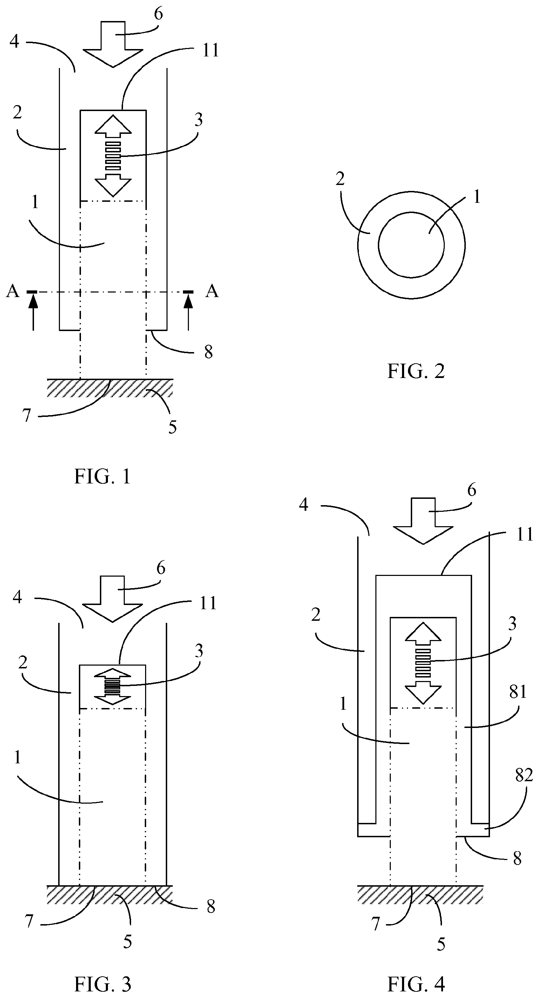

FIG. 1 schematically shows the main structure of the present invention;
FIG. 2 is a schematic cross-sectional view of the structure of FIG. 1 taken along Line A-A; and
FIG. 3 schematically shows the structure of FIG. 1 wherein a load threshold set therefor is surpassed. It primarily comprises the following components:
   -- the first force-receiving structure (1): being constructed from materials and structures having sufficient supporting capability, and configured to bear a pressure coming from the carrying end (4) through the limiting structure (11) and the pre-stressed structure (3) and acting between the contact structure (7) having lower friction damping of the first force-receiving structure (1) and the terminal support body (5) that contacts the contact structure (7) and is the ground, a structure platform, or a structural plane, meaning that the pre-stressed structure (3) is located between one side of the first force-receiving structure (1) and the limiting structure (11) that is extended from and linked to the second force-receiving structure (2), and the contact structure (7) having lower friction damping is provide at an opposite side of the first force-receiving structure (1) for contacting the terminal support body (5), so as to receive the prestress from the pre-stressed structure (3) and pass the prestress to the terminal support body (5) it contacts;
      wherein the contact structure (7) having lower friction damping of the first force-receiving structure (1) for contacting the terminal support body (5) is constructed from a terminal block (71) having lower friction damping that has sliding capability or a rolling wheel (72) or a rolling ball (73) that has rolling capability;
   -- the second force-receiving structure (2): being constructed from materials and structures having sufficient strength and supporting capability, having one end thereof provided with a contact structure (8) having higher friction damping, and having an opposite end served as a carrying end (4), the second force-receiving structure (2) further having the limiting structure (11) extended therefrom and linked thereto, for allowing the pre-stressed structure (3) to be provided between the limiting structure (11) and the first force-receiving structure (1), so that when a pressure acting between the carrying end (4) and first force-receiving structure (1) varies, the pre-stressed structure (3) generates corresponding displacement;
   -- the pre-stressed structure (3): being provided between the carrying end (4) and the first force-receiving structure (1), being capable of generating displacement corresponding to the pressure it receives, the pre-stressed structure (3) being constructed from a magnetic device, and the pre-stressed structure being of one or both of constant and adjustable arrangement; and
   -- the carrying end (4): being located at one side of the second force-receiving structure (2), for bearing a load caused by an external force or an object it carries;
With the aforementioned configuration, the carrier device capable of varying contact damping with pressured displacement has the functions including that:
   when a pressure transferred from the carrying end (4) through the limiting structure (11) to act between the pre-stressed structure (3) together with the first force-receiving structure (1) and the terminal support body (5) is smaller than a set value, the first force-receiving structure (1) has a contact structure (7) having lower friction damping at one end thereof solely contact the terminal support body (5), and at this time a contact structure (8) having higher friction damping between the second force-receiving structure (2) and the terminal support body (5) does not bear the pressure from the carrying end (4), or bears only a part of the pressure that is smaller than or equal to that acting on the contact structure (7) having lower friction damping of the first force-receiving structure (1), as shown in FIG. 1; and
   when a pressure transferred from the carrying end (4) through the limiting structure (11) to act between the pre-stressed structure (3) together with the first force-receiving structure (1) and the terminal support body (5) is greater than the set value, the first force-receiving structure (1) generates corresponding displacement, so that the contact structure (7) having lower friction damping and the contact structure (8) having higher friction damping of the second force-receiving structure (2) jointly contact the terminal support body (5), and at this time the pressure acting between the second force-receiving structure (2) and the terminal support body (5) is greater than or equal to that acting on the first force-receiving structure (1), as shown in FIG. 3;
The contact structure (7) having lower friction damping of the first force-receiving structure (1) for contacting the terminal support body (5) is constructed from one or more of the following structures:
   (1) a terminal block (71) having lower friction damping;
   (2) a rolling wheel (72); and
   (3) a rolling ball (73);
The structure of the second force-receiving structure (2) for contacting the terminal support body (5) is a contact structure (8) having higher friction damping constructed from materials and structural geometry that provide higher friction damping;
Under the same given pressure, the frictional resistance at the contact interface between the contact structure (7) having lower friction damping of the first force-receiving structure (1) and the terminal support body (5) is smaller than that at the contact interface between the contact structure (8) having higher friction damping of the second force-receiving structure (2) and the terminal support body (5);
The pressure acting between the carrying end (4) and the terminal support body (5) is a sum of its own weight and the load (6) put on the carrying end (4) and/or the pressure the carrying end (4) bears;
The carrier device capable of varying contact damping with pressured displacement without changing its operational principles may be further constructed from assembled structures;
The structure disclosed by FIG. 1 except for being constructed by combining the foregoing individual parts, it may alternatively be constructed by combining the first force-receiving structure (1), the pre-stressed structure (3), and the assembled auxiliary (81) for the second force-receiving structure first, and then combining the resulting assembly with the second force-receiving structure (2).

FIG. 4 schematically shows an embodiment of the assembled structure of FIG. 1.

As shown in FIG. 4, the assembled auxiliary (81) for the second force-receiving structure is installed between the second force-receiving structure (2) and the first force-receiving structure (1) together with its pre-stressed structure (3); the assembled auxiliary (81) for the second force-receiving structure at its one end close to the terminal support body (5) has a flange (82), the flange (82) has its bottom provided with a contact structure (8) having higher friction damping, the assembled auxiliary (81) for the second force-receiving structure contains therein the first force-receiving structure (1), the first force-receiving structure (1) at its one end is provided with a contact structure (7) having lower friction damping for contacting the terminal support body (5), and a pre-stressed structure (3) is provided between an opposite end of the first force-receiving structure (1) and the limiting structure (11);

The foregoing limiting structure (11) is constructed from a top structure of the assembled auxiliary (81) for the second force-receiving structure and/or from a structure extended from a carrying end (4) combined with the second force-receiving structure (2);
The structure shown in FIG. 1 and FIG. 2 and the assembled structure shown in FIG. 4 works as described below:
When pressure transferred from the carrying end (4) through the limiting structure (11) to act between the pre-stressed structure (3) together with the first force-receiving structure (1) and the terminal support body (5) is smaller than a set value, the first force-receiving structure (1) has the contact structure (7) having lower friction damping at one end thereof solely contact the terminal support body (5), and at this time the contact structure (8) having higher friction damping between the second force-receiving structure (2) and the terminal support body (5) does not bear the pressure from the carrying end (4), or bears only a part of the pressure that is smaller than or equal to that acting on the contact structure (7) having lower friction damping of the first force-receiving structure (1), as shown in FIG. 1;
When pressure transferred from the carrying end (4) through the limiting structure (11) to act between the pre-stressed structure (3) together with the first force-receiving structure (1) and the terminal support body (5) is greater than the set value, the first force-receiving structure (1) generates corresponding displacement, so that the contact structure (7) having lower friction damping and the contact structure (8) having higher friction damping of the second force-receiving structure (2) jointly contact the terminal support body (5), and at this time the pressure acting between the second force-receiving structure (2) and the terminal support body (5) is greater than or equal to that acting on the first force-receiving structure (1).

The carrier device capable of varying contact damping with pressured displacement may be formed into various structural forms sharing the same operational principles, and while some embodiments and related description will be discussed below for illustration, they are not intended to pose limitation to the present invention;
FIG. 5 shows an exemplary arrangement constructed from a magnetic pre-stressed device (31) and a terminal block (71) having lower friction damping.
FIG. 6 is a schematic cross-sectional view of the structure of FIG. 5 taken along Line A-A.

As shown in FIGs. 5 and 6, it primarily comprises the following components:
-- the first force-receiving structure (1): being constructed from a terminal block (71) having lower friction damping that is capable of shift in an inner space of the second force-receiving structure (2), a pre-stressed structure (3) constructed from a magnetic pre-stressed device (31) being provided between one end of the first force-receiving structure (1) and the limiting structure (11) extended from and linked to the second force-receiving structure (2), and a contact structure (7) having lower friction damping being provided at an opposite end of the first force-receiving structure (1) and facing the terminal support body (5);
-- the second force-receiving structure (2): being constructed from materials and structures having sufficient strength and supporting capability, having one end thereof combined with the carrying end (4), and having an opposite end thereof provided with a contact structure (8) having higher friction damping, and a pre-stressed structure (3) constructed from a magnetic pre-stressed device (31) being provided between the limiting structure (11) extended from and linked to the second force-receiving structure (2) and the first force-receiving structure (1) constructed from the terminal block (71) having lower friction damping; and
-- the magnetic pre-stressed device (31): including permanent magnets that are such arranged between the limiting structure (11) extended from and linked to the second force-receiving structure (2) and the first force-receiving structure (1) that they face each other with the same polarity so as to have mutual repellence;

An axial displacement limiting structure is provided between the first force-receiving structure (1) and the second force-receiving structure (2) for preventing the first force-receiving structure (1) from departing from the second force-receiving structure (2); in the present arrangement, the limiting function is realized by a guide slot (731) passing through the first force-receiving structure (1) and a pin (721) of the second force-receiving structure (2); and the foregoing axial displacement limiting structure constructed from the pin (721) and the guide slot (731) is merely one example and may be realized by alternative structures that have the same limiting capability.

The structure disclosed by FIG. 5 except for being constructed by combining the foregoing individual parts, it may alternatively be constructed by combining the first force-receiving structure (1), the pre-stressed structure (3), and the assembled auxiliary (81) for the second force-receiving structure first, and then combining the resulting assembly with the second force-receiving structure (2);
FIG. 7 schematically shows one example of the assembled structure of FIG. 5.

As shown in FIG. 7, it primarily comprises the following components:
-- the first force-receiving structure (1): being constructed from a terminal block (71) having lower friction damping and installed in an inner space of an assembled auxiliary (81) for the second force-receiving structure, so as to be able to shift in the inner space of the assembled auxiliary (81) for the second force-receiving structure, the first force-receiving structure (1) having one end thereof provided with a contact structure (7) having lower friction damping that faces the terminal support body (5), and a pre-stressed structure (3) constructed from a magnetic pre-stressed device (31) being provided between an opposite end of the first force-receiving structure (1) and a limiting structure (11) at the top of the inner space of the assembled auxiliary (81) for the second force-receiving structure;
-- the second force-receiving structure (2): being constructed from materials and structures having sufficient strength and supporting capability, having one end thereof combined with the carrying end (4), and having an opposite end thereof combined with the assembled auxiliary (81) for the second force-receiving structure;
-- the assembled auxiliary (81) for the second force-receiving structure: being installed in an inner space at one end of the second force-receiving structure (2) close to the terminal support body (5), the assembled auxiliary (81) for the second force-receiving structure having its structural end facing the terminal support body (5) provided with a flange (82), the flange (82) having its end facing the terminal support body (5) provided with a contact structure (8) having higher friction damping, the first force-receiving structure (1) being installed in the inner space of the assembled auxiliary (81) for the second force-receiving structure, a pre-stressed structure (3) constructed from a magnetic pre-stressed device (31) being provided between the assembled auxiliary (81) for the second force-receiving structure and the first force-receiving structure (1); the foregoing assembled auxiliary (81) for the second force-receiving structure and the second force-receiving structure (2) may be combined in one or more ways of:
   1) the two being combined by means of press-fit insertion;
   2) the two being combined by means of mating spiral structures;
   3) the two being fastened by laterally passing through pins;
   4) the two being fastened by laterally installed screws;
   5) the two being welded together; and
   6) the two being bonded together; and
-- the magnetic pre-stressed device (31): including permanent magnets that are such arranged between the limiting structure (11) at the top of the inner space of the assembled auxiliary (81) for the second force-receiving structure and one end of the first force-receiving structure (1) that they face each other with the same polarity so as to have mutual repellence;
An axial displacement limiting structure is provided between the first force-receiving structure (1) and the flange (82) of the assembled auxiliary (81) for the second force-receiving structure for preventing the first force-receiving structure (1) from departing from the assembled auxiliary (81) for the second force-receiving structure; in the present arrangement, limiting function is realized by a guide slot (731) passing through the first force-receiving structure (1) and a pin (721) of the assembled auxiliary (81) for the second force-receiving structure, and the foregoing axial displacement limiting structure constructed from the pin (721) and the guide slot (731), however, is merely one example and may be realized by alternative structures that have the same limiting capability.

FIG. 8 shows an exemplary arrangement constructed from a magnetic pre-stressed device (31) and a rolling wheel (72).

FIG. 9 is a schematic cross-sectional view of the structure of FIG. 8 taken along Line A-A

As shown in FIGs. 8 and 9, it primarily comprises the following components:
-- the first force-receiving structure (1): being constructed from a structure that is capable of shifting in an inner space of the second force-receiving structure (2), a pre-stressed structure (3) constructed from a magnetic pre-stressed device (31) being provided between one end of the first force-receiving structure (1) and the limiting structure (11) extended from and linked to the second force-receiving structure (2), a rolling wheel (72) being provided at an opposite end of the first force-receiving structure (1), and a shaft (723) and a bearing (720) being provided between the rolling wheel (72) and the second force-receiving structure (2);
-- the second force-receiving structure (2): being constructed from materials and structures having sufficient strength and supporting capability, having one end thereof combined with the carrying end (4), and having an opposite end thereof provided with a contact structure (8) having higher friction damping, and a pre-stressed structure (3) constructed from a magnetic pre-stressed device (31) being provided between the limiting structure (11) extended from and linked to the second force-receiving structure (2) and the first force-receiving structure (1) having a rolling wheel (72); and
-- the magnetic pre-stressed device (31): including permanent magnets that are such arranged between the limiting structure (11) extended from and linked to the second force-receiving structure (2) and the first force-receiving structure (1) that they face each other with the same polarity so as to have mutual repellence;
An axial displacement limiting structure is provided between the first force-receiving structure (1) and the second force-receiving structure (2) for preventing the first force-receiving structure (1) from departing from the second force-receiving structure (2); in the present arrangement, the limiting function is realized by a guide slot (731) passing through the first force-receiving structure (1) and a pin (721) of the second force-receiving structure (2), and the foregoing axial displacement limiting structure constructed from the pin (721) and the guide slot (731), however, is merely one example and may be realized by alternative structures that have the same limiting capability.

The structure disclosed by FIG. 8 except for being constructed by combining the foregoing individual parts, it may alternatively being constructed by combining the first force-receiving structure (1), the pre-stressed structure (3), and the assembled auxiliary (81) for the second force-receiving structure first, and then combining the resulting assembly with the second force-receiving structure (2);
FIG. 10 schematically shows an example of the assembled structure of FIG. 8.

As shown in FIG. 10, it primarily comprises the following components:
-- the first force-receiving structure (1): being installed in an inner space of the assembled auxiliary (81) for the second force-receiving structure and capable of shifting in the inner space of the assembled auxiliary (81) for the second force-receiving structure, the first force-receiving structure (1) having one end thereof provided with the rolling wheel (72) facing the terminal support body (5), and a pre-stressed structure (3) being provided between an opposite end of the first force-receiving structure (1) and the limiting structure (11) at the top of the inner space of the assembled auxiliary (81) for the second force-receiving structure, wherein the pre-stressed structure (3) is constructed from a magnetic pre-stressed device (31) in which permanent magnets face each other with the same polarity so as to have mutual repellence;
-- the second force-receiving structure (2): being constructed from materials and structures having sufficient strength and supporting capability, having one end thereof combined with the carrying end (4), and having an opposite end thereof combined with the assembled auxiliary (81) for the second force-receiving structure;
-- the assembled auxiliary (81) for the second force-receiving structure: being installed in an inner space of the second force-receiving structure (2) at its one end close to the terminal support body (5), the assembled auxiliary (81) for the second force-receiving structure having its structural end facing the terminal support body (5) provided with a flange (82), the flange (82) having its end facing the terminal support body (5) provided with a contact structure (8) having higher friction damping, the first force-receiving structure (1) being installed in the inner space of the assembled auxiliary (81) for the second force-receiving structure, a pre-stressed structure (3) constructed from a magnetic pre-stressed device (31) being provided between the assembled auxiliary (81) for the second force-receiving structure and the first force-receiving structure (1); and the foregoing assembled auxiliary (81) for the second force-receiving structure and the second force-receiving structure (2) may be combined in one or more ways of:
   1) the two being combined by means of press-fit insertion;
   2) the two being combined by means of mating spiral structures;
   3) the two being fastened by laterally passing through pins;
   4) the two being fastened by laterally installed screws;
   5) the two being welded together; and
   6) the two being bonded together; and
-- the magnetic pre-stressed device (31): including permanent magnets that are such arranged between the limiting structure (11) at the top of the inner space of the assembled auxiliary (81) for the second force-receiving structure and the first force-receiving structure (1) that they face each other with the same polarity so as to have mutual repellence;
An axial displacement limiting structure is provided between the first force-receiving structure (1) and the flange (82) of the assembled auxiliary (81) for the second force-receiving structure for preventing the first force-receiving structure (1) from departing from the assembled auxiliary (81) for the second force-receiving structure; in the present arrangement, the limiting function is realized by a guide slot (731) passing through the first force-receiving structure (1) and a pin (721) of the assembled auxiliary (81) for the second force-receiving structure, and the foregoing axial displacement limiting structure constructed from the pin (721) and the guide slot (731), however, is merely one example and may be realized by alternative structures that have the same limiting capability.

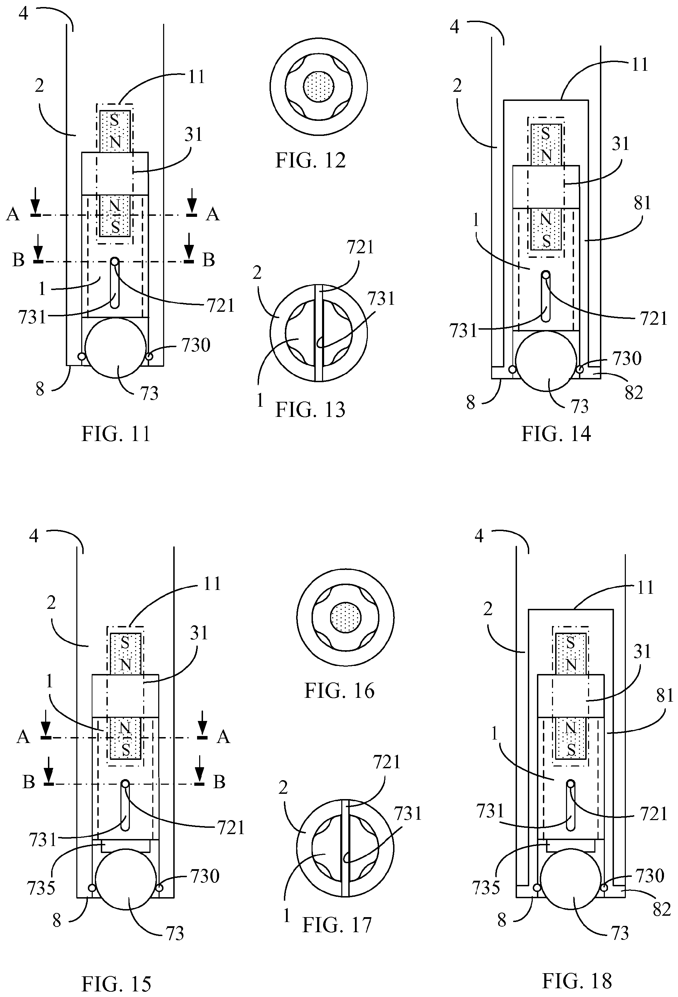

FIG. 11 shows an exemplary arrangement constructed from a magnetic pre-stressed device (31) and a rolling ball (73).

FIG. 12 is a schematic cross-sectional view of the structure of FIG. 11 taken along Line A-A.

FIG. 13 is a schematic cross-sectional view of the structure of FIG. 11 taken along Line B-B.

As shown in FIGs. 11, 12 and 13, it primarily comprises the following components:
-- the first force-receiving structure (1): being constructed from a structure that is capable of shifting in the inner space of the second force-receiving structure (2), a pre-stressed structure (3) constructed from a magnetic pre-stressed device (31) being provided between one end of the first force-receiving structure (1) and the limiting structure (11) extended from and linked to the carrying end (4), and an opposite end of the first force-receiving structure (1) being provided with a rolling ball (73);
-- the second force-receiving structure (2): being constructed from materials and structures having sufficient strength and supporting capability, having one end thereof combined with the carrying end (4), and having an opposite end thereof provided with a contact structure (8) having higher friction damping, and a pre-stressed structure (3) constructed from a magnetic pre-stressed device (31) being provided between the limiting structure (11) of the carrying end (4) and the first force-receiving structure (1) having the rolling ball (73); and
-- the magnetic pre-stressed device (31): including permanent magnets that are such arranged between the limiting structure (11) extended from and linked to the second force-receiving structure (2) and the first force-receiving structure (1) that they face each other with the same polarity so as to have mutual repellence;
An axial displacement limiting device is provided between the first force-receiving structure (1) and the second force-receiving structure (2) for preventing the first force-receiving structure (1) from departing from the second force-receiving structure (2); in the present arrangement, the limiting function is realized by a guide slot (731) passing through the first force-receiving structure (1) and a pin (721) of the second force-receiving structure (2); in the present arrangement, after the rolling ball (73) is placed in the second force-receiving structure (2), a limiting ring (730) is installed at the inner side of the opening of the second force-receiving structure (2) facing the terminal support body (5) so as to form a limiting structure that prevents the rolling ball (73) from coming off; the foregoing limiting structure for preventing both the first force-receiving structure (1) and the rolling ball (73) from coming off is merely one example and may be realized by alternative structures that have the same limiting capability.

The structure disclosed by FIG. 11 except for being constructed by combining the foregoing individual parts, it may alternatively being constructed by combining the first force-receiving structure (1), the pre-stressed structure (3), and the assembled auxiliary (81) for the second force-receiving structure first, and then combining the resulting assembly with the second force-receiving structure (2);
FIG. 14 schematically shows one example of the assembled structure of FIG. 11.

As shown in FIG. 14, it primarily comprises the following components:
-- the first force-receiving structure (1): being installed in an inner space of the assembled auxiliary (81) for the second force-receiving structure and capable of shifting in an inner space of the assembled auxiliary (81) for the second force-receiving structure, the first force-receiving structure (1) having its one end provided with a rolling ball (73) facing the terminal support body (5), and a pre-stressed structure (3) constructed from a magnetic pre-stressed device (31) being provided between an opposite end of the first force-receiving structure (1) and a limiting structure (11) at the top of the inner space of the assembled auxiliary (81) for the second force-receiving structure;
-- the second force-receiving structure (2): being constructed from materials and structures having sufficient strength and supporting capability, having one end thereof combined with the carrying end (4), and having an opposite end thereof combined with the assembled auxiliary (81) for the second force-receiving structure;
-- the assembled auxiliary (81) for the second force-receiving structure: being installed at one end of the second force-receiving structure (2) close to the terminal support body (5), the assembled auxiliary (81) for the second force-receiving structure having its structural end facing the terminal support body (5) provided with a flange (82), the flange (82) having its end facing the terminal support body (5) provided with a contact structure (8) having higher friction damping, the first force-receiving structure (1) being installed in the inner space of the assembled auxiliary (81) for the second force-receiving structure, a pre-stressed structure (3) constructed from a magnetic pre-stressed device (31) being provided between the assembled auxiliary (81) for the second force-receiving structure and the first force-receiving structure (1); wherein the foregoing assembled auxiliary (81) for the second force-receiving structure and the second force-receiving structure (2) may be combined in one or more ways of:
   1) the two being combined by means of press-fit insertion;
   2) the two being combined by means of mating spiral structures;
   3) the two being fastened by laterally passing through pins;
   4) the two being fastened by laterally installed screws;
   5) the two being welded together; and
   6) the two being bonded together; and
-- the magnetic pre-stressed device (31): including permanent magnets that are such arranged between the limiting structure (11) at the top of the inner space of the assembled auxiliary (81) for the second force-receiving structure and one end of the first force-receiving structure (1) that they face each other with the same polarity so as to have mutual repellence;
An axial displacement limiting structure is provided between the first force-receiving structure (1) and the flange (82) of the assembled auxiliary (81) for the second force-receiving structure for preventing the first force-receiving structure (1) from departing from the assembled auxiliary (81) for the second force-receiving structure; in the present arrangement, the limiting function is realized by a guide slot (731) passing through the first force-receiving structure (1) and a pin (721) of the assembled auxiliary (81) for the second force-receiving structure; in the present arrangement, after the rolling ball (73) is placed in the second force-receiving structure (2), a limiting ring (730) is installed at the inner side of the opening of the assembled auxiliary (81) for the second force-receiving structure facing the terminal support body (5) so as to form a limiting structure that prevents the rolling ball (73) from coming off; and the foregoing limiting structure for preventing both the first force-receiving structure (1) and the rolling ball (73) from coming off is merely one example and may be realized by alternative structures that have the same limiting capability.

FIG. 15 schematically shows an example of the arrangement according to FIG. 11 wherein an intermediate pad (735) is provided between the magnetic pre-stressed device (31) and the rolling ball (73).

FIG. 16 is a schematic cross-sectional view of the structure of FIG. 15 taken along Line A-A.

FIG. 17 is a schematic cross-sectional view of the structure of FIG. 15 taken along Line B-B.

As shown in FIGs. 15, 16 and 17, the structure as shown in the arrangement of FIG. 11 includes the following components:
-- the first force-receiving structure (1);
-- the second force-receiving structure (2);
-- the magnetic pre-stressed device (31); and
-- an axial displacement limiting device being provided between the first force-receiving structure (1) and the second force-receiving structure (2) for preventing the first force-receiving structure (1) from departing from the second force-receiving structure (2); and having a limiting structure that prevents the rolling ball (73) from coming off;
Therein, an intermediate pad (735) is provided between the magnetic pre-stressed device (31) and the rolling ball (73), for reducing abrasion caused by direct contact between the rolling ball (73) and the magnetic pre-stressed device (31).

The structure disclosed by FIG. 15 except for being constructed by combining the foregoing individual parts, it may alternatively being constructed by combining the first force-receiving structure (1), the pre-stressed structure (3), and the assembled auxiliary (81) for the second force-receiving structure first, and then combining the resulting assembly with the second force-receiving structure (2).

FIG. 18 schematically shows an example of the assembled structure of FIG. 15.

As shown in FIG. 18, it primarily comprises the following components:
-- the first force-receiving structure (1);
-- the second force-receiving structure (2);
-- the assembled auxiliary (81) for the second force-receiving structure;
-- the magnetic pre-stressed device (31); and
-- an axial displacement limiting structure being provided between the first force-receiving structure (1) and the flange (82) of the assembled auxiliary (81) for the second force-receiving structure, for preventing the first force-receiving structure (1) from departing from the assembled auxiliary (81) for the second force-receiving structure; and having a limiting structure that prevents the rolling ball (73) from coming off;
Therein, an intermediate pad (735) is provided between the magnetic pre-stressed device (31) and the rolling ball (73), for reducing abrasion caused by direct contact between the rolling ball (73) and the magnetic pre-stressed device (31).

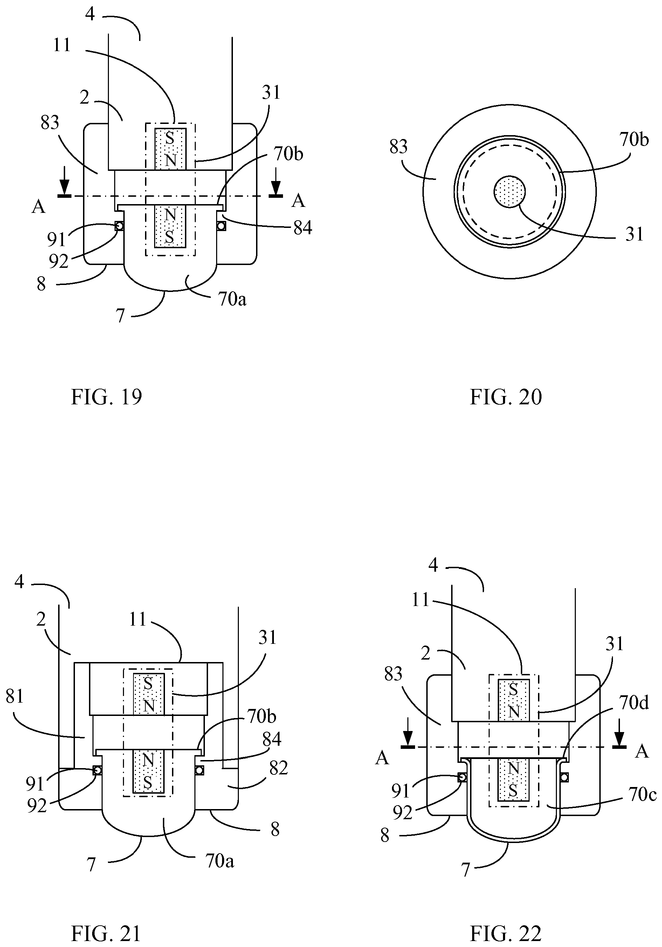

FIG. 19 schematically shows an exemplary arrangement constructed from a magnetic pre-stressed device (31) and a semi-spherical terminal block (70a).

FIG. 20 is a schematic cross-sectional view of the structure of FIG. 19 taken along Line A-A.

As shown in FIGs. 19 and 20, it primarily comprises the following components:
-- the first force-receiving structure (1): being constructed from a semi-spherical terminal block (70a) that is capable of shifting in the inner space of the second force-receiving structure (2), a pre-stressed structure (3) constructed from a magnetic pre-stressed device (31) being provided between one end of the first force-receiving structure (1) and the limiting structure (11) extended from and linked to the second force-receiving structure (2), and a contact structure (7) having lower friction damping being provided at an opposite end of the semi-spherical terminal block (70a);
-- the second force-receiving structure (2): being constructed from materials and structures having sufficient strength and supporting capability, having one end thereof combined with the carrying end (4), and having an opposite end thereof provided with a contact structure (8) having higher friction damping, and a pre-stressed structure (3) constructed from a magnetic pre-stressed device (31) being provided between a limiting structure (11) extended from and linked to the second force-receiving structure (2) and the first force-receiving structure (1) having the semi-spherical terminal block (70a);
-- the magnetic pre-stressed device (31): configured by permanent magnets that are such arranged between the limiting structure (11) extended from and linked to the second force-receiving structure (2) and the first force-receiving structure (1) having the semi-spherical terminal block (70a) that they face each other with the same polarity so as to have mutual repellence that allows them to form the pre-stressed structure (3); and
-- the outer auxiliary (83) for second force-receiving structure : being a tubular structure made of materials and structures having sufficient strength and supporting capability, having one end thereof combined with the outer periphery of the second force-receiving structure (2), and having an opposite end thereof provided with a contact structure (8) having higher friction damping and an inwardly-retracted flange (84), and the outer auxiliary (83) for second force-receiving structure and the second force-receiving structure (2) being combined by means of screwed structures or interference fit or fit that is followed by pin fixing.

Therein the semi-spherical terminal block (70a) of the first force-receiving structure (1) is of a semi-spherical structure, with its lower side having a spherical projecting end facing the terminal support body (5) constructed as a contact structure (7) having lower friction damping, and with its upper end provided with the permanent magnet composing the magnetic pre-stressed device (31), an outward-expanding annular flange structure (70b) is provided at its upper periphery for engaging with the inwardly-retracted flange (84) of the outer auxiliary (83) for second force-receiving structure thereby preventing disengagement;
When the pressure between the carrying end (4) and the terminal support body (5) contacted by the contact structure (7) having lower friction damping is smaller than a set value, the contact structure (8) having higher friction damping of the second force-receiving structure (2), does not contact the terminal support body (5);
When the pressure between the carrying end (4) and the terminal support body (5) contacted by the contact structure (7) having lower friction damping is greater than the set value, the semi-spherical terminal block (70a) is pressured and displaced, so the contact structure (7) having lower friction damping and the contact structure (8) having higher friction damping of the second force-receiving structure (2) jointly contact the terminal support body (5).

The structure disclosed by FIG. 19 except for being constructed by combining the foregoing individual parts, it may alternatively being constructed by combining the first force-receiving structure (1), the pre-stressed structure (3), and the assembled auxiliary (81) for the second force-receiving structure first, and then combining the resulting assembly with the second force-receiving structure (2);

FIG. 21 schematically shows an example of the assembled structure of FIG. 19.

As shown in FIG. 21, it primarily comprises the following components:
-- the first force-receiving structure (1);
-- the second force-receiving structure (2);
-- the assembled auxiliary (81) for the second force-receiving structure: being installed at one end of the second force-receiving structure (2) close to the terminal support body (5), the assembled auxiliary (81) for the second force-receiving structure having its structural end facing the terminal support body (5) provided with a flange (82), the flange (82) having its end facing the terminal support body (5) provided with a contact structure (8) having higher friction damping, the inner space of the assembled auxiliary (81) for the second force-receiving structure at its end facing the terminal support body (5) being provided with the first force-receiving structure (1) having the semi-spherical terminal block (70a), and at where between the semi-spherical terminal block (70a) and the inner space of the assembled auxiliary (81) for the second force-receiving structure at its end facing the limiting structure (11) is provided with a pre-stressed structure (3) constructed from a magnetic pre-stressed device (31); wherein the foregoing assembled auxiliary (81) for the second force-receiving structure and the second force-receiving structure (2) may be combined in one or more ways of:
   1) the two being combined by means of press-fit insertion;
   2) the two being combined by means of mating spiral structures;
   3) the two being fastened by laterally passing through pins;
   4) the two being fastened by laterally installed screws;
   5) the two being welded together; and
   6) the two being bonded together; and
-- the magnetic pre-stressed device (31): including permanent magnets that are such arranged between the limiting structure (11) extended from and linked to the second force-receiving structure (2) and the first force-receiving structure (1) having the semi-spherical terminal block (70a) that they face each other with the same polarity so as to have mutual repellence;

Therein the semi-spherical terminal block (70a) of the first force-receiving structure (1) is of a semi-spherical structure, with its lower side having a spherical projecting end facing the terminal support body (5) constructed as a contact structure (7) having lower friction damping, and with its upper end provided with the permanent magnet composing the magnetic pre-stressed device (31), an outward-expanding annular flange structure (70b) is provided at its upper periphery for engaging with the inwardly-retracted flange (84) of the flange (82) of the assembled auxiliary (81) for the second force-receiving structure thereby preventing disengagement;
When the pressure between the carrying end (4) and the terminal support body (5) contacted by the contact structure (7) having lower friction damping of the semi-spherical terminal block (70a) is smaller than a set value, the contact structure (8) having higher friction damping of the second force-receiving structure (2) does not contact the terminal support body (5);
When the pressure between the carrying end (4) and the terminal support body (5) contacted by the contact structure (7) having lower friction damping of the semi-spherical terminal block (70a) is greater than the set value, the semi-spherical terminal block (70a) is pressured and displaced, so the contact structure (7) having lower friction damping and the contact structure (8) having higher friction damping of the second force-receiving structure (2) jointly contact the terminal support body (5).

In the arrangements depicted in FIGs. 19, 20 and 21, the semi-spherical terminal block (70a) and the outward-expanding annular flange structure (70b) may be constructed from a semi-spherical cup-shaped structure (70c), the semi-spherical cup-shaped structure (70c) has an outwardly-extended annular sheet (70d), the foregoing semi-spherical cup-shaped structure (70c) may be used instead of the semi-spherical terminal block (70a), and the outwardly-extended annular sheet (70d) can be in place of the outward-expanding annular flange structure (70b) at the upper periphery of the semi-spherical terminal block (70a).

FIG. 22 schematically shows one example of the structure of FIG. 19, wherein the semi-spherical terminal block (70a) is replaced with a semi-spherical cup-shaped structure (70c).

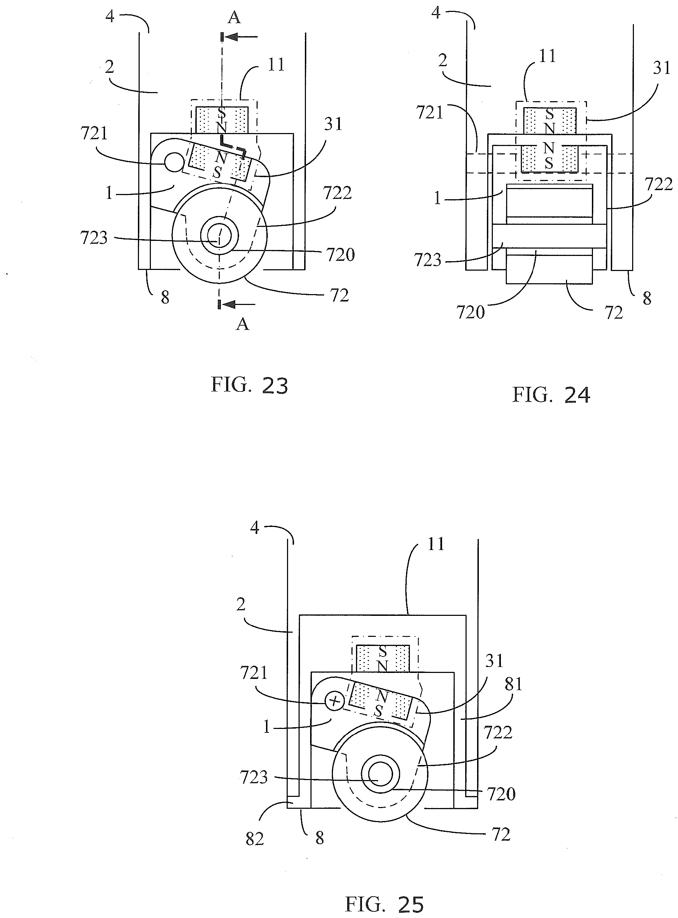

FIG. 23 schematically shows one example constructed from a magnetic pre-stressed device (31) and a rolling wheel (72), which is of a one-side swinging structure.

FIG. 24 is a schematic cross-sectional view of the structure of FIG. 23 taken along Line A-A.

As shown in FIGs. 23 and 24, it primarily comprises the following components:
-- the first force-receiving structure (1): being constructed from a structure that is capable of swinging against the pin (721) in the inner space of the second force-receiving structure (2), a pre-stressed structure (3) constructed from a magnetic pre-stressed device (31) being provided between one end of the first force-receiving structure (1) and the limiting structure (11) extended from and linked to the second force-receiving structure (2), and a wheel arm (722) on which a shaft (723), a bearing (720) and a rolling wheel (72) are installed being provided at an opposite end of the first force-receiving structure (1);
-- the second force-receiving structure (2): being constructed from materials and structures having sufficient strength and supporting capability, having one end thereof combined with the carrying end (4), and having an opposite end thereof provided with a contact structure (8) having higher friction damping, and a pre-stressed structure (3) constructed from a magnetic pre-stressed device (31) being provided between the limiting structure (11) extended from and linked to the second force-receiving structure (2) and the first force-receiving structure (1) having a rolling wheel (72); and
-- the magnetic pre-stressed device (31): including permanent magnets that are such arranged between the limiting structure (11) extended from and linked to the second force-receiving structure (2) and the first force-receiving structure (1) that they face each other with the same polarity so as to have mutual repellence.

The structure disclosed by FIG. 23 except for being constructed by combining the foregoing individual parts, it may alternatively being constructed by combining the first force-receiving structure (1), the pre-stressed structure (3), and the assembled auxiliary (81) for the second force-receiving structure first, and then combining the resulting assembly with the second force-receiving structure (2);

FIG. 25 schematically shows one example of the assembled structure of FIG. 23.

As shown in FIG. 25, it primarily comprises the following components:
-- the first force-receiving structure (1): being installed in an inner space of the assembled auxiliary (81) for the second force-receiving structure and capable of swinging against the pin (721) in the inner space of the assembled auxiliary (81) for the second force-receiving structure, the first force-receiving structure (1) having one end thereof provided with a wheel arm (722) for the installation of a shaft (723) and a bearing (720) and facing the terminal support body (5), and a pre-stressed structure (3) being provided between an opposite end of the first force-receiving structure (1) and the limiting structure (11) at the top of the inner space of the assembled auxiliary (81) for the second force-receiving structure, wherein the pre-stressed structure (3) is constructed from a magnetic pre-stressed device (31) in which permanent magnets face each other with the same polarity so as to have mutual repellence;
-- the second force-receiving structure (2): being constructed from materials and structures having sufficient strength and supporting capability, having one end thereof combined with the carrying end (4), and having an opposite end thereof combined with the assembled auxiliary (81) for the second force-receiving structure;
-- the assembled auxiliary (81) for the second force-receiving structure: being installed in an inner space at one end of the second force-receiving structure (2) close to the terminal support body (5), the assembled auxiliary (81) for the second force-receiving structure having its structural end facing the terminal support body (5) provided with a flange (82), the flange (82) having its end facing the terminal support body (5) provided with a contact structure (8) having higher friction damping, the first force-receiving structure (1) swinging in the inner space of the assembled auxiliary (81) for the second force-receiving structure against the pin (721), a pre-stressed structure (3) constructed from a magnetic pre-stressed device (31) being provided between the assembled auxiliary (81) for the second force-receiving structure and the first force-receiving structure (1); wherein the foregoing assembled auxiliary (81) for the second force-receiving structure and the second force-receiving structure (2) may be combined in one or more ways of:
   1) the two being combined by means of press-fit insertion;
   2) the two being combined by means of mating spiral structures;
   3) the two being fastened by laterally passing through pins;
   4) the two being fastened by laterally installed screws;
   5) the two being welded together; and
   6) the two being bonded together; and
-- the magnetic pre-stressed device (31): including permanent magnets that are such arranged between the limiting structure (11) at the top of the inner space of the assembled auxiliary (81) for the second force-receiving structure and one end of the first force-receiving structure (1) that they face each other with the same polarity so as to have mutual repellence.

In the carrier device capable of varying contact damping with pressured displacement of the present application, the pre-stressed structure (3) that generates displacement corresponding to the pressure it receives in addition to the foregoing structures providing pressured displacement using energy stored as compressive prestress, it may have structures providing pressured displacement using energy stored as expansive prestress, such as those described in the embodiments below.

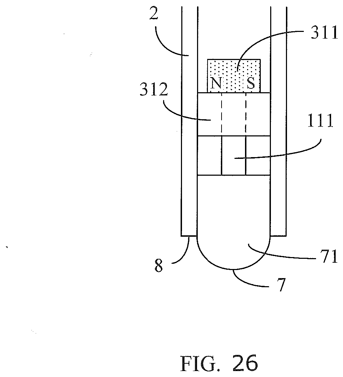

FIG. 26 is the first schematic structural embodiment of the present invention showing the pre-stressed structure (3) providing pressured displacement using energy stored as expansive prestress.

As shown in FIG. 26, the magnetic pre-stressed device (31) made of the permanent magnets that are arranged to have mutual repellence mutual as shown in FIG. 5 is replaced with a structure wherein the permanent magnet (311) connected to the terminal block (71) having lower friction damping through the guide rod (111) work with the magnetic conductive member (312) provided at the second force-receiving structure (2) to generate mutual attraction, which pushes the terminal block (71) having lower friction damping to be exposed outside the contact structure (8) having higher friction damping of the second force-receiving structure (2), and wherein when the terminal block (71) having lower friction damping is pressed and performs retracting displacement, the magnetic attraction between the permanent magnet (311) and the magnetic conductive member (312) is stored for providing a required pre-stressed force for the terminal block (71) having lower friction damping to return.

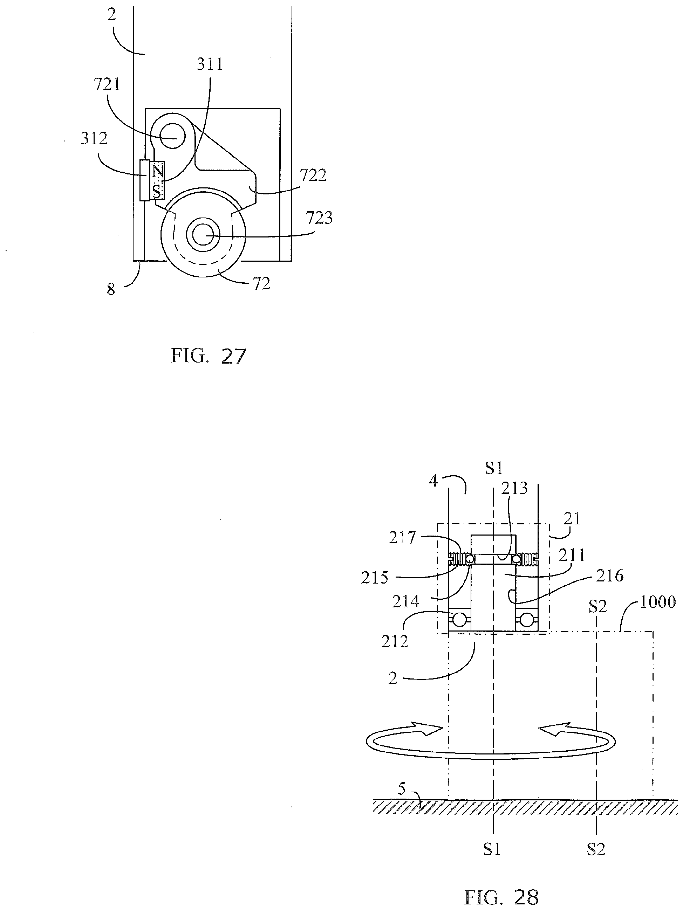

FIG. 27 is the second schematic structural embodiment of the present invention showing the pre-stressed structure (3) providing pressured displacement using energy stored as expansive prestress.

As shown in FIG. 27, the magnetic pre-stressed device (31) of FIG. 23 is replaced with a permanent magnet (311) and a magnetic conductive member (312), the magnetic conductive member (312) is installed inside the second force-receiving structure (2), and the permanent magnet (311) is installed at one side of the wheel arm (722) facing the magnetic conductive member (312), so as to provide magnetic attraction that drives the wheel arm (722) to swing and in turn expose the rolling wheel (72) outside the contact structure (8) having higher friction damping of the second force-receiving structure (2), and when the rolling wheel (72) is pressed and performs retracting displacement, the magnetic attraction between the permanent magnet (311) and the magnetic conductive member (312) is in a pre-stressed state storing required energy for the rolling wheel (72) to return.

In the practical uses, the carrier device capable of varying contact damping with pressured displacement of the present invention maybe combined with traditional interface mechanisms for enriched applications or for lengthened service life. A relevant example is discussed below.

FIG. 28 schematically shows an embodiment that the present invention is provided with the axial rotating structure (21).

As shown in FIG. 28, with the shaft post (211) and the bearing (212) provided on the second force-receiving structure (2) of the carrier device assembly (1000) capable of varying contact damping with pressured displacement, rotation between the carrying end (4) and the carrier device assembly (1000) capable of varying contact damping with pressured displacement is achieved;
The structure primarily includes the following components:
   -- the carrier device assembly (1000) capable of varying contact damping with pressured displacement: being a structure constructed according to the principles as shown in FIG. 1 through FIG. 4 (at least including the arrangements of FIGs. 26 and 27), wherein the pressure line (S2) of the first force-receiving structure (1) and the terminal support body (5) does not coincide with the revolving axial line (S1) on which the carrier device assembly (1000) capable of varying contact damping with pressured displacement and the carrying end (4) revolve, so that the pressure line (S2) of the first force-receiving structure (1) and the terminal support body (5) can revolve against the revolving axial line (S1) at the carrying end.
The axial rotating structure (21) is constructed from:
   -- shaft post (211): being a shaft post structure extending from the second force-receiving structure (2) of the carrier device assembly (1000) capable of varying contact damping with pressured displacement toward the carrying end (4), for enabling the hole seat (216) combined with the carrying end (4) to revolve, a bearing (212) being provided therebetween, and an axial positioning annular slot (213) being provided at the shaft post (211), wherein the positioning ball (214) provided at the lateral screw hole (217) of the hole seat (216) of the carrying end (4) and the positioning bolt (215) prevents the shaft post (211) from leaving the hole seat (216).

With the foregoing structure, axial rolling between the carrier device capable of varying contact damping with pressured displacement and the carrying end (4) can be achieved.

In addition, the carrier device capable of varying contact damping with pressured displacement of the present invention may form a sealing function through the combination of a conventional sealing ring (91) and an annular sealing slot (92) between the first force-receiving structure (1) and the second force-receiving structure (2), between the first force-receiving structure (1) and the assembled auxiliary (81) for the second force-receiving structure, or between the semi-spherical terminal block (70a)/annular flange structure (70b)/semi-spherical cup-shaped structure (70c)/outwardly-extended annular sheet (70d)/terminal block (71) having lower friction damping and the second force-receiving structure (2), thereby lengthening its service life.

## Claims

1. A carrier device capable of varying contact damping with pressured displacement, comprising a second force-receiving structure (2) providing one end thereof as a carrying end (4) for bearing a load or stress, the second force-receiving structure (2) has a limiting structure (11) extended therefrom and linked thereto that works with a magnetic pre-stressed device (31),
the carrier device further comprising a first force-receiving structure (1), the first force-receiving structure (1) and the second force-receiving structure (2) can jointly transfer the pressure from the load or stress to a terminal support body (5) when the first force-receiving structure (1) and the second force-receiving structure (2) are both located between the carrying end (4) and the terminal support body (5) so as to function as desired by varying force distribution between the first and second force-receiving structures (1),(2) and the terminal support body (5) with the pressure acting on the carrying end (4);
wherein, the magnetic pre-stressed device (31) is provided between the first force-receiving structure (1) and the limiting structure (11) that is extended from and linked to the second force-receiving structure (2), and forms a structure that generates displacement corresponding to a force it receives;
-- the first force-receiving structure (1): being constructed from materials and structures having sufficient supporting capability, and having a first contact structure (7), and configured to bear a pressure coming from the carrying end (4) through the limiting structure (11) and the magnetic pre-stressed device (31) and acting between the first contact structure (7) having lower friction damping of the first force-receiving structure (1) and the terminal support body (5) when contacting the first contact structure (7), wherein the terminal support body is the ground, a structure platform, or a structural plane, and the first contact structure (7) having lower friction damping is provided at an opposite side of the first force-receiving structure (1) for contacting the terminal support body (5), so as to receive the prestress from the magnetic pre-stressed device (31) and pass the prestress to the terminal support body (5) it contacts;
-- the second force-receiving structure (2): being constructed from materials and structures having sufficient strength and supporting capability, having one end thereof provided with a contact structure (8) having higher friction damping, and having an opposite end serving as the carrying end (4), wherein when a pressure acting between the carrying end (4) and first force-receiving structure (1) varies, the magnetic pre-stressed device (31) generates corresponding displacement;
-- the magnetic pre-stressed device (31): being provided between the carrying end (4) and the first force-receiving structure (1), being capable of generating displacement corresponding to the pressure it receives, the magnetic pre-stressed device (31) being of one or both of constant and adjustable arrangement; and
wherein with the aforementioned configuration, the carrier device capable of varying contact damping with pressured displacement has the functions including that:
when a pressure transferred from the carrying end (4) through the limiting structure (11) to act between the magnetic pre-stressed device (31) together with the first force-receiving structure (1) and the terminal support body (5) is smaller than a set value, the first contact structure (7) having lower friction damping at one end thereof solely contacts the terminal support body (5), and at this time the second contact structure (8) having higher friction damping between the second force-receiving structure (2) and the terminal support body (5) does not bear the pressure from the carrying end (4), or bears only a part of the pressure that is smaller than or equal to that acting on the first contact structure (7) having lower friction damping of the first force-receiving structure (1); and
when a pressure transferred from the carrying end (4) through the limiting structure (11) to act between the magnetic pre-stressed device (31) together with the first force-receiving structure (1) and the terminal support body (5) is greater than the set value, the first force-receiving structure (1) generates corresponding displacement, so that the contact structure (7) having lower friction damping and the contact structure (8) having higher friction damping of the second force-receiving structure (2) jointly contact the terminal support body (5), and at this time the pressure acting between the second force-receiving structure (2) and the terminal support body (5) is greater than or equal to that acting on the first force-receiving structure (1);
wherein the first contact structure (7) is constructed from one or more of the following structures:
1) a terminal block (71) having lower friction damping;
2) a rolling wheel (72); and
3) a rolling ball (73);
wherein the second contact structure (8) having higher friction damping is constructed from materials and structural geometry that provide higher friction damping than the first contact structure;
wherein under the same given pressure, the frictional resistance at the contact interface between the first contact structure (7) having lower friction damping of the first force-receiving structure (1) and the terminal support body (5) is smaller than that at the contact interface between the second contact structure (8) having higher friction damping of the second force-receiving structure (2) and the terminal support body (5);
wherein the pressure acting between the carrying end (4) and the terminal support body (5) is a sum of its own weight and the load (6) put on the carrying end (4) and/or the pressure the carrying end (4) bears,
wherein the magnetic pre-stressed device (31) comprises a permanent magnet (311) connected to the first contact structure (7), and a magnetic conductive member (312) provided at the second force receiving structure (2),
**characterised in that** the permanent magnet (311) works with the magnetic conductive member (312) to generate mutual attraction which pushes the first contact structure (7) to be exposed outside the second contact structure (8), and
**in that** when the first contact structure (7) is pressed and performs retracting displacement, the magnetic attraction between the permanent magnet (311) and the magnetic conductive member (312) is stored for providing a pre-stressed force for the first contact structure (7) to return to being exposed outside the second contact structure (8).

2. A carrier device as claimed in claim 1, wherein:
-- the first force-receiving structure (1): being constructed from a terminal block (71) having lower friction damping that is capable of shift in an inner space of the second force-receiving structure (2), the magnetic pre-stressed device (31) being provided between one end of the first force-receiving structure (1) and the limiting structure (11) extended from and linked to the second force-receiving structure (2), and a first contact structure (7) having lower friction damping being provided at an opposite end of the first force-receiving structure (1) and facing the terminal support body (5); and an axial displacement limiting structure is provided between the first force-receiving structure (1) and the second force-receiving structure (2) for preventing the first force-receiving structure (1) from departing from the second force-receiving structure (2); the limiting function is realized by a guide slot (731) passing through the first force-receiving structure (1) and a pin (721) of the second force-receiving structure (2).

3. A carrier device as claimed in claim 2, wherein the permanent magnet of the magnetic pre-stressed device (31) works with the magnetic conductive member (312) provided at the second force-receiving structure (2) to generate mutual attraction which pushes the terminal block (71) to be exposed outside the second contact structure (8), and
wherein when the terminal block (71) having lower friction damping is pressed and performs retracting displacement, the magnetic attraction between the permanent magnet (311) and the magnetic conductive member (312) is stored for providing a pre-stressed force for the terminal block to return to being exposed outside the second contact structure (8).

4. A carrier device as claimed in claim 1, wherein the first force-receiving structure (1) is constructed from a rolling wheel (72), which is of a one-side swinging structure, and it primarily comprises the following components:
-- the first force-receiving structure (1): being constructed from a structure that is capable of swinging against a pin (721) in the inner space of the second force-receiving structure (2), the magnetic pre-stressed device (31) being provided between one end of the first force-receiving structure (1) and the limiting structure (11) extended from and linked to the second force-receiving structure (2), and a wheel arm (722) on which a shaft (723), a bearing (720) and a rolling wheel (72) are installed being provided at an opposite end of the first force-receiving structure (1).

5. A carrier device as claimed in claim 4, wherein the magnetic conductive member (312) is installed inside the second force-receiving structure (2), and the permanent magnet (311) is installed at one side of the wheel arm (722) facing the magnetic conductive member (312), so as to provide magnetic attraction that drives the wheel arm (722) to swing and in turn expose the rolling wheel (72) outside the second contact structure (8), and
wherein when the rolling wheel (72) is pressed and performs retracting displacement, the magnetic attraction between the permanent magnet (311) and the magnetic conductive member (312) is stored for providing a pre-stressed force for the rolling wheel (72) to return to being exposed outside the second contact structure (8).

6. A carrier device as claimed in claim 1, wherein being applied in the mechanical force-receiving structures that have rolling wheels, rolling balls or slidably displaceable terminal block structure.

## Patentansprüche

1. Trägervorrichtung mit Fähigkeit zum Ändern der Kontaktdämpfung mit Druckverdrängung, eine zweite Kraftaufnahmestruktur (2) umfassend, die ein Ende davon als tragendes Ende (4) zum Aufnehmen einer Last oder Spannung bereitstellt, die zweite Kraftaufnahmestruktur (2) weist eine Begrenzungsstruktur (11) auf, die sich von dort erstreckt und damit verbunden ist, die mit einer magnetischen vorgespannten Vorrichtung (31) zusammenwirkt,
die Trägervorrichtung ferner umfassend eine erste Kraftaufnahmestruktur (1), die erste Kraftaufnahmestruktur (1) und die zweite Kraftaufnahmestruktur (2) können gemeinsam den Druck von der Last oder Spannung auf einen Anschlussstützkörper (5) übertragen, wenn sich die erste Kraftaufnahmestruktur (1) und die zweite Kraftaufnahmestruktur (2) beide zwischen dem tragenden Ende (4) und dem Anschlussstützkörper (5) befinden, um durch variierende Kraftverteilung zwischen der ersten und zweiten Kraftaufnahmestruktur (1), (2) und dem Anschlussstützkörper (5) mit dem auf das tragende Ende (4) wirkenden Druck wie gewünscht zu funktionieren;
wobei die magnetische vorgespannte Vorrichtung (31) zwischen der ersten Kraftaufnahmestruktur (1) und der Begrenzungsstruktur (11) bereitgestellt ist, die sich von der zweiten Kraftaufnahmestruktur (2) erstreckt und mit dieser verbunden ist, und eine Struktur bildet, die eine Verschiebung entsprechend einer Kraft erzeugt, die sie aufnimmt;
-- wobei die erste Kraftaufnahmestruktur (1): aus Materialien und Strukturen mit ausreichender Tragfähigkeit aufgebaut ist und eine erste Kontaktstruktur (7) aufweist und konfiguriert ist, um einem Druck standzuhalten, der vom tragenden Ende (4) über die Begrenzungsstruktur (11) und die magnetische vorgespannte Vorrichtung (31) gelangt und zwischen der ersten Kontaktstruktur (7) mit geringerer Reibungsdämpfung der ersten Kraftaufnahmestruktur (1) und dem Anschlussstützkörper (5) wirkt, wenn sie die erste Kontaktstruktur (7) berührt, wobei der Anschlussstützkörper der Boden, eine Strukturplattform oder eine Strukturebene ist und die erste Kontaktstruktur (7) mit geringerer Reibungsdämpfung auf einer der ersten Kraftaufnahmestruktur (1) gegenüberliegenden Seite zum Kontaktieren des Anschlussstützkörpers (5) bereitgestellt ist, um die Vorspannung von der magnetischen vorgespannten Vorrichtung (31) aufzunehmen und an den Anschlussstützkörper (5), mit dem sie in Kontakt steht, weiterzuleiten;
-- wobei die zweite Kraftaufnahmestruktur (2): aus Materialien und Strukturen mit ausreichender Festigkeit und Tragfähigkeit aufgebaut ist, ein Ende davon aufweist, das mit einer Kontaktstruktur (8) mit höherer Reibungsdämpfung bereitgestellt ist, und ein gegenüberliegendes Ende aufweist, das als tragendes Ende (4) dient, wobei die magnetische vorgespannte Vorrichtung (31) eine entsprechende Verschiebung erzeugt, wenn ein zwischen dem tragenden Ende (4) und der ersten Kraftaufnahmestruktur (1) wirkender Druck variiert;
-- wobei die magnetische vorgespannte Vorrichtung (31): zwischen dem tragenden Ende (4) und der ersten Kraftaufnahmestruktur (1) bereitgestellt ist und eine Verschiebung entsprechend dem von ihr aufgenommenen Druck erzeugen kann, wobei die magnetische vorgespannte Vorrichtung (31) eines oder beides von einer konstanten und einer einstellbaren Anordnung ist; und
wobei bei der zuvor genannten Konfiguration die Trägervorrichtung mit Fähigkeit zum Ändern der Kontaktdämpfung mit Druckverdrängung folgende Funktionen hat, einschließlich:
wenn ein vom tragenden Ende (4) über die Begrenzungsstruktur (11) übertragener Druck, der zwischen der magnetischen vorgespannten Vorrichtung (31) zusammen mit der ersten Kraftaufnahmestruktur (1) und dem Anschlussstützkörper (5) wirken soll, kleiner als ein festgelegter Wert ist, kontaktiert die erste Kontaktstruktur (7) mit geringerer Reibungsdämpfung an einem Ende davon ausschließlich den Anschlussstützkörper (5), und zu diesem Zeitpunkt trägt die zweite Kontaktstruktur (8) mit höherer Reibungsdämpfung zwischen der zweiten Kraftaufnahmestruktur (2) und dem Anschlussstützkörper (5) den Druck vom tragenden Ende (4) nicht oder nur einen Teil des Drucks, der kleiner als oder gleich dem Druck ist, der auf die erste Kontaktstruktur (7) mit geringerer Reibungsdämpfung der ersten Kraftaufnahmestruktur (1) wirkt; und
wenn ein vom Trägerende (4) über die Begrenzungsstruktur (11) übertragener Druck, der zwischen der magnetischen vorgespannten Vorrichtung (31) zusammen mit der ersten Kraftaufnahmestruktur (1) und dem Anschlussstützkörper (5) wirken soll, größer als der eingestellte Wert ist, erzeugt die erste Kraftaufnahmestruktur (1) eine entsprechende Verschiebung, so dass die Kontaktstruktur (7) mit geringerer Reibungsdämpfung und die Kontaktstruktur (8) mit höherer Reibungsdämpfung der zweiten Kraftaufnahmestruktur (2) gemeinsam den Anschlussstützkörper (5) kontaktieren, und zu diesem Zeitpunkt ist der zwischen der zweiten Kraftaufnahmestruktur (2) und dem Anschlussstützkörper (5) wirkende Druck größer als oder gleich dem auf die erste Kraftaufnahmestruktur (1) wirkenden Druck;
wobei die erste Kontaktstruktur (7) aus einer oder mehreren der folgenden Strukturen aufgebaut ist:
1) ein Anschlussblock (71) mit geringerer Reibungsdämpfung;
2) ein Rollrad (72); und
3) eine Rollkugel (73);
wobei die zweite Kontaktstruktur (8) mit höherer Reibungsdämpfung aus Materialien und mit einer Strukturgeometrie aufgebaut ist, die eine höhere Reibungsdämpfung als die erste Kontaktstruktur bereitstellen;
wobei bei gleichem Druck der Reibungswiderstand an der Kontaktschnittstelle zwischen der ersten Kontaktstruktur (7) mit geringerer Reibungsdämpfung der ersten Kraftaufnahmestruktur (1) und dem Anschlussstützkörper (5) kleiner ist als an der Kontaktschnittstelle zwischen der zweiten Kontaktstruktur (8) mit höherer Reibungsdämpfung der zweiten Kraftaufnahmestruktur (2) und dem Anschlussstützkörper (5);
wobei der zwischen dem tragenden Ende (4) und dem Anschlussstützkörper (5) wirkende Druck sich aus seinem Eigengewicht und der auf das tragende Ende (4) ausgeübten Last (6) und/oder dem vom tragenden Ende (4) ausgehaltenen Druck ergibt,
wobei die magnetische vorgespannte Vorrichtung (31) einen Permanentmagneten (311), der mit der ersten Kontaktstruktur (7) verbunden ist, und ein magnetisches leitendes Element (312) umfasst, das an der zweiten Kraftaufnahmestruktur (2) bereitgestellt ist,
**dadurch gekennzeichnet, dass** der Permanentmagnet (311) mit dem magnetischen leitenden Element (312) zusammenwirkt, um eine gegenseitige Anziehung zu erzeugen, die die erste Kontaktstruktur (7) aus der zweiten Kontaktstruktur (8) durch Herausdrücken freilegt, und
dass, wenn die erste Kontaktstruktur (7) gedrückt wird und eine Rückzugsverschiebung durchführt, die magnetische Anziehung zwischen dem Permanentmagneten (311) und dem magnetischen leitenden Element (312) gespeichert wird, um eine vorgespannte Kraft bereitzustellen, damit die erste Kontaktstruktur (7) wieder außerhalb der zweiten Kontaktstruktur (8) freiliegt.

2. Trägervorrichtung nach Anspruch 1, wobei:
-- die erste Kraftaufnahmestruktur (1): aus einem Anschlussblock (71) mit geringerer Reibungsdämpfung aufgebaut ist, der sich in einem Innenraum der zweiten Kraftaufnahmestruktur (2) verschieben kann, wobei die magnetische vorgespannte Vorrichtung (31) zwischen einem Ende der ersten Kraftaufnahmestruktur (1) und der Begrenzungsstruktur (11) bereitgestellt ist, die sich von der zweiten Kraftaufnahmestruktur (2) erstreckt und mit dieser verbunden ist, und wobei an einem gegenüberliegenden Ende der ersten Kraftaufnahmestruktur (1) und gegenüber dem Anschlussstützkörper (5) eine erste Kontaktstruktur (7) mit geringerer Reibungsdämpfung bereitgestellt ist; und zwischen der ersten Kraftaufnahmestruktur (1) und der zweiten Kraftaufnahmestruktur (2) eine axiale Verschiebungsbegrenzungsstruktur bereitgestellt ist, um zu verhindern, dass sich die erste Kraftaufnahmestruktur (1) von der zweiten Kraftaufnahmestruktur (2) löst; die Begrenzungsfunktion durch einen Führungsschlitz (731) ausgeführt ist, der durch die erste Kraftaufnahmestruktur (1) und einen Stift (721) der zweiten Kraftaufnahmestruktur (2) verläuft.

3. Trägervorrichtung nach Anspruch 2, wobei der Permanentmagnet der magnetischen vorgespannten Vorrichtung (31) mit dem magnetischen leitenden Element (312) zusammenwirkt, das an der zweiten Kraftaufnahmestruktur (2) bereitgestellt ist, um eine gegenseitige Anziehung zu erzeugen, die den Anschlussblock (71) aus der zweiten Kontaktstruktur (8) durch Herausdrücken freilegt, und
wobei, wenn der Anschlussblock (71) mit geringerer Reibungsdämpfung gedrückt wird und eine Rückzugsverschiebung durchführt, die magnetische Anziehung zwischen dem Permanentmagneten (311) und dem magnetischen leitenden Element (312) gespeichert wird, um eine vorgespannte Kraft bereitzustellen, damit der Anschlussblock wieder außerhalb der zweiten Kontaktstruktur (8) freiliegt.

4. Trägervorrichtung nach Anspruch 1, wobei die erste Kraftaufnahmestruktur (1) aus einem Rollrad (72) aufgebaut ist, das eine einseitig schwingende Struktur aufweist, und sie umfasst im Wesentlichen die folgenden Komponenten:
-- wobei die erste Kraftaufnahmestruktur (1): aufgebaut ist aus einer Struktur, die gegen einen Stift (721) im Innenraum der zweiten Kraftaufnahmestruktur (2) schwingen kann, wobei die magnetische vorgespannte Vorrichtung (31) zwischen einem Ende der ersten Kraftaufnahmestruktur (1) und der Begrenzungsstruktur (11) bereitgestellt ist, die sich von der zweiten Kraftaufnahmestruktur (2) erstreckt und mit dieser verbunden ist, und wobei ein Radarm (722), an dem eine Welle (723), ein Lager (720) und ein Rollrad (72) installiert sind, an einem gegenüberliegenden Ende der ersten Kraftaufnahmestruktur (1) bereitgestellt ist.

5. Trägervorrichtung nach Anspruch 4, wobei das magnetische leitende Element (312) innerhalb der zweiten Kraftaufnahmestruktur (2) installiert ist und der Permanentmagnet (311) an einer Seite des Radarms (722) gegenüber dem magnetischen leitenden Element (312) installiert ist, um eine magnetische Anziehungskraft bereitzustellen, die den Radarm (722) zum Schwingen bringt und wiederum das Rollrad (72) außerhalb der zweiten Kontaktstruktur (8) freilegt, und
wobei, wenn das Rollrad (72) gedrückt wird und eine Rückzugsverschiebung durchführt, die magnetische Anziehung zwischen dem Permanentmagneten (311) und dem magnetischen leitenden Element (312) gespeichert wird, um eine vorgespannte Kraft bereitzustellen, damit das Rollrad (72) wieder außerhalb der zweiten Kontaktstruktur (8) freiliegt.

6. Trägervorrichtung nach Anspruch 1, wobei diese in den mechanischen Kraftaufnahmestrukturen angewendet wird, die Rollräder, Rollkugeln oder eine verschiebbare Anschlussblockstruktur aufweisen.

## Revendications

1. Dispositif porteur pouvant faire varier un amortissement de contact avec un déplacement sous pression, comprenant une seconde structure réceptrice de force (2) fournissant une extrémité associée en tant qu'extrémité porteuse (4) pour supporter une charge ou une contrainte, la seconde structure réceptrice de force (2) est prolongée à partir de et liée à une structure de limitation (11) qui fonctionne avec un dispositif de précontrainte magnétique (31),
le dispositif porteur comprenant en outre une première structure réceptrice de force (1), la première structure réceptrice de force (1) et la seconde structure réceptrice de force (2) peuvent conjointement transférer la pression de la charge ou de la contrainte à un corps de soutien terminal (5) lorsque la première structure réceptrice de force (1) et la seconde structure réceptrice de force (2) sont toutes deux situées entre l'extrémité porteuse (4) et le corps de soutien terminal (5) de manière à fonctionner comme souhaité en faisant varier une répartition de force entre les première et seconde structures réceptrices de force (1), (2) et le corps de soutien terminal (5) avec la pression agissant sur l'extrémité porteuse (4) ;
dans lequel le dispositif de précontrainte magnétique (31) est placé entre la première structure réceptrice de force (1) et la structure de limitation (11) qui est prolongée à partir de la seconde structure réceptrice de force (2) et liée à celle-ci, et forme une structure qui génère un déplacement correspondant à une force qu'elle reçoit ;
-- la première structure réceptrice de force (1) : étant construite à partir de matériaux et de structures ayant une capacité de soutien suffisante, et ayant une première structure de contact (7), et conçue pour supporter une pression venant de l'extrémité porteuse (4) par le biais de la structure de limitation (11) et du dispositif de précontrainte magnétique (31) et agissant entre la première structure de contact (7) ayant un amortissement par friction plus faible de la première structure réceptrice de force (1) et le corps de soutien terminal (5) lors du contact avec la première structure de contact (7), dans lequel le corps de soutien terminal est le sol, une plate-forme de structure ou un plan structurel, et la première structure de contact (7) ayant un amortissement par friction plus faible est placée au niveau d'un côté opposé de la première structure réceptrice de force (1) pour entrer en contact avec le corps de soutien terminal (5), de manière à recevoir la précontrainte en provenance du dispositif de précontrainte magnétique (31) et à transmettre la précontrainte au corps de soutien terminal (5) avec lequel elle entre en contact ;
-- la seconde structure réceptrice de force (2) : étant construite à partir de matériaux et de structures ayant une résistance et une capacité de soutien suffisantes, dont une des extrémités est dotée d'une structure de contact (8) ayant un amortissement par friction plus élevé, et dont une extrémité opposée sert d'extrémité porteuse (4), dans lequel, lorsqu'une pression agissant entre l'extrémité porteuse (4) et la première structure réceptrice de force (1) varie, le dispositif de précontrainte magnétique (31) génère un déplacement correspondant ;
-- le dispositif de précontrainte magnétique (31) : étant placé entre l'extrémité porteuse (4) et la première structure réceptrice de force (1), pouvant générer un déplacement correspondant à la pression qu'il reçoit, le dispositif de précontrainte magnétique (31) étant de type constant ou ajustable, ou les deux à la fois ; et
dans lequel, avec la configuration susmentionnée, le dispositif porteur pouvant faire varier un amortissement de contact avec un déplacement sous pression a les fonctions suivantes :
lorsqu'une pression transférée de l'extrémité porteuse (4) par le biais de la structure de limitation (11) pour agir entre le dispositif de précontrainte magnétique (31) avec la première structure réceptrice de force (1) et le corps de soutien terminal (5) est inférieure à une valeur définie, la première structure de contact (7) ayant un amortissement par friction plus faible au niveau de l'une de ses extrémités entre uniquement en contact avec le corps de soutien terminal (5), et à ce moment-là, la seconde structure de contact (8) ayant un amortissement par friction plus élevé entre la seconde structure réceptrice de force (2) et le corps de soutien terminal (5) ne supporte pas la pression de l'extrémité porteuse (4), ou ne supporte qu'une partie de la pression qui est inférieure ou égale à celle agissant sur la première structure de contact (7) ayant un amortissement par friction plus faible de la première structure réceptrice de force (1) ; et
lorsqu'une pression transférée de l'extrémité porteuse (4) par le biais de la structure de limitation (11) pour agir entre le dispositif de précontrainte magnétique (31) avec la première structure réceptrice de force (1) et le corps de soutien terminal (5) est supérieure à la valeur définie, la première structure réceptrice de force (1) génère un déplacement correspondant, de sorte que la structure de contact (7) ayant un amortissement par friction plus faible et la structure de contact (8) ayant un amortissement par friction plus élevé de la seconde structure réceptrice de force (2) entrent conjointement en contact avec le corps de soutien terminal (5), et à ce moment-là, la pression agissant entre la seconde structure réceptrice de force (2) et le corps de soutien terminal (5) est supérieure ou égale à celle agissant sur la première structure réceptrice de force (1) ;
dans lequel la première structure de contact (7) est construite à partir d'une ou plusieurs des structures suivantes :
1) un bloc terminal (71) ayant un amortissement par friction plus faible ;
2) une roue de roulement (72) ; et
3) une bille de roulement (73) ;
dans lequel la seconde structure de contact (8) ayant un amortissement par friction plus élevé est construite à partir de matériaux et d'une géométrie structurelle qui offrent un amortissement par friction plus élevé que la première structure de contact ;
dans lequel, sous la même pression donnée, la résistance à la friction au niveau de l'interface de contact entre la première structure de contact (7) ayant un amortissement par friction plus faible de la première structure réceptrice de force (1) et le corps de soutien terminal (5) est inférieure à celle au niveau de l'interface de contact entre la seconde structure de contact (8) ayant un amortissement par friction plus élevé de la seconde structure réceptrice de force (2) et le corps de soutien terminal (5) ;
dans lequel la pression agissant entre l'extrémité porteuse (4) et le corps de soutien terminal (5) est une somme de son propre poids et de la charge (6) exercée sur l'extrémité porteuse (4) et/ou de la pression supportée par l'extrémité porteuse (4),
dans lequel le dispositif de précontrainte magnétique (31) comprend un aimant permanent (311) relié à la première structure de contact (7), et un élément conducteur magnétique (312) placé au niveau de la seconde structure réceptrice de force (2),
**caractérisé en ce que** l'aimant permanent (311) fonctionne avec l'élément conducteur magnétique (312) pour générer une attraction mutuelle qui pousse la première structure de contact (7) à être exposée à l'extérieur de la seconde structure de contact (8), et
**en ce que**, lorsque la première structure de contact (7) est pressée et réalise un déplacement de rétraction, l'attraction magnétique entre l'aimant permanent (311) et l'élément conducteur magnétique (312) est stockée pour fournir une force de précontrainte à la première structure de contact (7) afin qu'elle soit à nouveau exposée à l'extérieur de la seconde structure de contact (8).

2. Dispositif porteur selon la revendication 1, dans lequel :
-- la première structure réceptrice de force (1) : étant construite à partir d'un bloc terminal (71) ayant un amortissement par friction plus faible pouvant se déplacer dans un espace intérieur de la seconde structure réceptrice de force (2), le dispositif de précontrainte magnétique (31) étant placé entre une extrémité de la première structure réceptrice de force (1) et la structure de limitation (11) prolongée à partir de la seconde structure réceptrice de force (2) et liée à celle-ci, et une première structure de contact (7) ayant un amortissement par friction plus faible étant placée au niveau d'une extrémité opposée de la première structure réceptrice de force (1) et faisant face au corps de soutien de terminal (5) ; et une structure de limitation du déplacement axial est placée entre la première structure réceptrice de force (1) et la seconde structure réceptrice de force (2) pour empêcher la première structure réceptrice de force (1) de s'écarter de la seconde structure réceptrice de force (2) ; la fonction de limitation est obtenue par une fente de guidage (731) traversant la première structure réceptrice de force (1) et un axe (721) de la seconde structure réceptrice de force (2).

3. Dispositif porteur selon la revendication 2, dans lequel l'aimant permanent du dispositif de précontrainte magnétique (31) fonctionne avec l'élément conducteur magnétique (312) placé au niveau de la seconde structure réceptrice de force (2) pour générer une attraction mutuelle qui pousse le bloc terminal (71) à être exposé à l'extérieur de la seconde structure de contact (8), et
dans lequel, lorsque le bloc terminal (71) ayant un amortissement par friction plus faible est pressé et réalise un déplacement de rétraction, l'attraction magnétique entre l'aimant permanent (311) et l'élément conducteur magnétique (312) est stockée pour fournir une force de précontrainte afin que le bloc terminal soit à nouveau exposé à l'extérieur de la seconde structure de contact (8).

4. Dispositif porteur selon la revendication 1, dans lequel la première structure réceptrice de force (1) est construite à partir d'une roue de roulement (72), qui est d'une structure oscillante d'un seul côté, et comprend principalement les composants suivants :
-- la première structure réceptrice de force (1) : étant construit à partir d'une structure pouvant osciller contre un axe (721) dans l'espace intérieur de la seconde structure réceptrice de force (2), le dispositif de précontrainte magnétique (31) étant placé entre une extrémité de la première structure réceptrice de force (1) et la structure de limitation (11) prolongée à partir de la seconde structure réceptrice de force (2) et liée à celle-ci, et un bras de roue (722) sur lequel sont installés un arbre (723), un support (720) et une roue de roulement (72) est placé au niveau d'une extrémité opposée de la première structure réceptrice de force (1).

5. Dispositif porteur selon la revendication 4, dans lequel l'élément conducteur magnétique (312) est installé à l'intérieur de la seconde structure réceptrice de force (2), et l'aimant permanent (311) est installé au niveau d'un côté du bras de roue (722) en face de l'élément conducteur magnétique (312), de manière à fournir une attraction magnétique qui entraîne le bras de roue (722) à osciller et à exposer à son tour la roue de roulement (72) à l'extérieur de la seconde structure de contact (8), et
dans lequel, lorsque la roue de roulement (72) est pressée et réalise un déplacement de rétraction, l'attraction magnétique entre l'aimant permanent (311) et l'élément conducteur magnétique (312) est stockée pour fournir une force de précontrainte à la roue de roulement (72) afin qu'elle soit à nouveau exposée à l'extérieur de la seconde structure de contact (8).

6. Dispositif porteur selon la revendication 1, dans lequel, les structures réceptrices de force mécanique sont dotées de roues de roulement, de billes de roulement ou d'une structure de bloc terminal pouvant être déplacée par coulissement.
